# EUROPEAN PATENT APPLICATION

(11) **EP 1 760 777 A2**
(43) Date of publication of application: **07.03.2007**
(21) Application number: 06120019.2
(22) Date of filing: 01.09.2006
(51) Int. Cl.: H01L 21/8238, H01L 27/092

(54) **Transistors and methods of manufacture thereof**

(30) Priority: 02.09.2005 US 219368
(71) Applicant: Infineon Technologies AG, 81669 München (DE)
(72) Inventor: Luan, Hongfa, Austin, TX 78759 (US); Schulz, Thomas, 3001, Haverlee (BE)
(74) Representative: Viering, Jentschura & Partner

(57) **Abstract**

Transistors and methods of manufacture thereof are disclosed. A complimentary metal oxide semiconductor (CMOS) device includes a PMOS transistor having a first gate electrode comprising a first thickness, and an NMOS transistor having a first gate electrode comprising a second thickness, wherein the first thickness is greater than the second thickness. The first gate electrode and the second gate electrode preferably comprise the same material, and may comprise TiSiN, TaN, or TiN, as examples. The thickness of the first gate electrode and the second gate electrode set the work function of the PMOS and NMOS transistors.

## Description

### TECHNICAL FIELD

The present invention relates generally to semiconductor devices, and more particularly to complimentary metal oxide semiconductor (CMOS) devices and methods of manufacture thereof.

### BACKGROUND

Semiconductor devices are used in a variety of electronic applications, such as personal computers, cell phones, digital cameras, and other electronic equipment, as examples. Semiconductor devices are typically fabricated by sequentially depositing insulating or dielectric layers, conductive layers, and semiconductive layers of material over a semiconductor substrate, and patterning the various layers using lithography to form circuit components and elements thereon.

A transistor is an element that is utilized extensively in semiconductor devices. There may be millions of transistors on a single integrated circuit (IC), for example. A common type of transistor used in semiconductor device fabrication is a metal oxide semiconductor field effect transistor (MOSFET).

Early MOSFET processes used one type of doping to create single transistors that comprised either positive or negative channel transistors. Other more recent designs, referred to as complimentary MOS (CMOS) devices, use both positive and negative channel devices, e.g., a positive channel metal oxide semiconductor (PMOS) transistor and a negative channel metal oxide semiconductor (NMOS) transistor, in complimentary configurations. An NMOS device negatively charges so that the transistor is turned on or off by the movement of electrons, whereas a PMOS device involves the movement of electron vacancies. While the manufacturing of CMOS devices requires more manufacturing steps and more transistors, CMOS devices are advantageous because they utilize less power, and the devices may be made smaller and faster.

The gate dielectric for MOSFET devices has in the past typically comprised silicon dioxide, which has a dielectric constant of about 3.9. However, as devices are scaled down in size, using silicon dioxide for a gate dielectric material becomes a problem because of gate leakage current, which can degrade device performance. Therefore, there is a trend in the industry towards the development of the use of high dielectric constant (k) materials for use as the gate dielectric material in MOSFET devices. The term "high k dielectric materials" as used herein refers to dielectric materials having a dielectric constant of about 4.0 or greater, for example.

High k gate dielectric material development has been identified as one of the future challenges in the 2002 edition of International Technology Roadmap for Semiconductors (ITRS), which is incorporated herein by reference, which identifies the technological challenges and needs facing the semiconductor industry over the next 15 years. For low power logic (for portable electronic applications, for example), it is important to use devices having low leakage current, in order to extend battery life. Gate leakage current must be controlled in low power applications, as well as sub-threshold leakage, junction leakage, and band-to-band tunneling.

In electronics, the "work function" is the energy, usually measured in electron volts, needed to remove an electron from the Fermi level to a point an infinite distance away outside the surface. Work function is a material property of any material, whether the material is a conductor, semiconductor, or dielectric.

The work function of a semiconductor material can be changed by doping the semiconductor material. For example, undoped polysilicon has a work function of about 4.65 eV, whereas polysilicon doped with boron has a work function of about 5.15 eV. When used as a gate electrode, the work function of a semiconductor or conductor directly affects the threshold voltage of a transistor, for example.

In prior art CMOS devices utilizing SiO₂ as the gate dielectric material and polysilicon as the gate electrode, the work function of the polysilicon could be changed or tuned by doping the polysilicon (e.g., implanting the polysilicon with dopants). However, high k gate dielectric materials such as hafnium-based dielectric materials exhibit a Fermi-pinning effect, which is caused by the interaction of the high k gate dielectric material with the adjacent gate material. When used as a gate dielectric, some types of high k gate dielectric materials can pin or fix the work function, so that doping the polysilicon gate material does not change the work function. Thus, a symmetric Vₜ for the NMOS and PMOS transistors of a CMOS device having a high k dielectric material for the gate dielectric cannot be achieved by doping polysilicon gate material, as in SiO₂ gate dielectric CMOS devices.

The Fermi-pinning effect of high k gate dielectric materials causes a threshold voltage shift and low mobility, due to the increased charge caused by the Fermi-pinning effect. Fermi-pinning of high k gate dielectric material causes an assymmetric turn-on threshold voltage Vₜ for the transistors of a CMOS device, which is undesirable. Efforts have been made to improve the quality of high k dielectric films and resolve the Fermi-pinning problems, but the efforts have resulted in little success.

Metal would be preferred over polysilicon as a gate material, to avoid a gate depletion effect and reduce the equivalent oxide thickness (EOT) of the gate dielectric. However, suitable metals have not yet been found for use as metal gates of CMOS devices, particularly for CMOS devices having high k dielectric materials for gate dielectric materials.

Thus, what are needed in the art are metal gate electrodes that have a suitable work function for CMOS device designs.

### SUMMARY OF THE INVENTION

These and other problems are generally solved or circumvented, and technical advantages are generally achieved, by preferred embodiments of the present invention, which comprise novel structures and methods of forming gate electrodes of semiconductor devices. Metals that have a tunable or adjustable work function by varying the thickness of the material are used as gate electrode materials, and the metal thickness is adjusted for PMOS and NMOS devices to achieve the desired work function.

In accordance with a preferred embodiment of the present invention, a semiconductor device includes a first transistor, the first transistor including a first gate electrode, the first gate electrode having a first thickness, and a second transistor proximate the first transistor. The second transistor includes a second gate electrode, the second gate electrode having a second thickness, and the second thickness being different than the first thickness.

In accordance with another preferred embodiment of the present invention, a semiconductor device includes a PMOS transistor including a first gate electrode comprising a first thickness, and an NMOS transistor including a second gate electrode comprising a second thickness, the second thickness being less than the first thickness, the second gate electrode comprising the same material as the first gate electrode. The first thickness and the second thickness of the first gate electrode and the second gate electrode, respectively, set the work function of the PMOS transistor and the NMOS transistor, respectively.

In accordance with yet another preferred embodiment of the present invention, a method of manufacturing a semiconductor device includes providing a workpiece, forming a gate dielectric material over the workpiece, and forming a gate electrode material over the gate dielectric material. The gate electrode material has a first thickness in a first region and a second thickness in a second region, the second thickness being different than the first thickness. The gate electrode material and the gate dielectric material are patterned to form a gate electrode and a gate dielectric of a first transistor in the first region and a gate electrode and a gate dielectric of a second transistor in the second region. A source region and a drain region are formed in the workpiece proximate the gate dielectric of the first transistor and the second transistor.

Advantages of preferred embodiments of the present invention include providing novel methods of fabricating transistor devices and structures thereof. CMOS devices may be manufactured wherein the PMOS transistor and NMOS transistor of the CMOS devices have a substantially symmetric Vₜ. The thickness of the metal gate materials sets the work function of the transistor gate electrodes, and establishes the threshold voltage Vₜ of the transistors. Because the portion of the gates proximate the gate dielectric material is metal, a gate depletion effect is avoided, resulting in a reduced equivalent oxide thickness (EOT). The same material is preferably used for the gate of the PMOS and NMOS transistor, resulting in reduced efforts in the deposition and etching of two different materials, and resulting in the prevention of contamination in manufacturing process tools.

The foregoing has outlined rather broadly the features and technical advantages of embodiments of the present invention in order that the detailed description of the invention that follows may be better understood. Additional features and advantages of embodiments of the invention will be described hereinafter, which form the subject of the claims of the invention. It should be appreciated by those skilled in the art that the conception and specific embodiments disclosed may be readily utilized as a basis for modifying or designing other structures, such as capacitors or gated diodes, as examples, or other processes for carrying out the same purposes of the present invention. It should also be realized by those skilled in the art that such equivalent constructions do not depart from the spirit and scope of the invention as set forth in the appended claims.

### BRIEF DESCRIPTION OF THE DRAWINGS

For a more complete understanding of the present invention and the advantages thereof, reference is now made to the following descriptions taken in conjunction with the accompanying drawings, in which:

Figures 1 through 5 show cross-sectional views of a semiconductor device at various stages of manufacturing in accordance with a preferred embodiment of the present invention, wherein a CMOS device comprises a PMOS transistor and an NMOS transistor having different gate material thicknesses;

Figures 6 through 8 show cross-sectional views of another method of manufacturing a CMOS device in accordance with an embodiment of the present invention; and

Figures 9 through 12 are graphs illustrating experimental test results of flat band voltage versus effective oxide thickness (EOT) at various test conditions and device configurations, showing that TiSiN is an effective material that may be used as a gate material to achieve the desired work function of the PMOS and NMOS transistors of a CMOS device by varying the thickness of the TiSiN.

Corresponding numerals and symbols in the different figures generally refer to corresponding parts unless otherwise indicated. The figures are drawn to clearly illustrate the relevant aspects of the preferred embodiments and are not necessarily drawn to scale.

### DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

When used as a gate dielectric of a transistor, the use of high k gate dielectric materials has generally been shown to yield orders of magnitude lower gate leakage current than SiO₂ gate dielectric materials with the same effective oxide thickness (EOT). For low standby power (LSTP) and high performance (HP) applications, a high k gate dielectric material is a potential solution in the roadmap for advanced technology nodes. High k gate dielectric materials are expected to achieve the EOT, gate leakage (J_{g}), mobility, and hysteresis parameters required by LSTP applications.

However, Vₜ controllability with high k gate dielectric materials is proving challenging. For example, in order for high k gate dielectric materials to be useful in CMOS applications, a CMOS device requires a symmetrical Vₜₙ and Vₜₚ (e.g., Vₜₙ = +0.3 V and Vₜₚ =-0.3 V).

Attempts to use high k dielectric materials as a gate dielectric material have been problematic. In particular, attempts have been made to use HfO₂, which is a high k dielectric material having a dielectric constant of about 25, as a gate dielectric for the PMOS and NMOS FETs of a CMOS device. If polysilicon is used as a gate material, the work function of the polysilicon gate using a HfO₂ gate dielectric has been found to be pinned, as a result of Fermi-pinning, at a point close to the conduction band of polysilicon, causing the polysilicon gate to function as N type polysilicon, even for a polysilicon gate doped with P type dopant, for the PMOS device. This has been found to cause asymmetric threshold voltages Vₜ for the PMOS and NMOS transistors of CMOS devices. Polysilicon used as a material for a gate electrode will also cause a poly depletion problem, for example.

Because the Fermi-pinning effect makes polysilicon incompatible for use as a gate material (e.g., used directly adjacent the gate dielectric), it is desirable to find a metal that may be used for PMOS and NMOS devices as a gate material.

It has been found that conventional bulk single-gate planar MOSFET devices probably cannot achieve the requested performance for future technology nodes of 45 nm and beyond. The classic bulk device concept is based on a complex three-dimensional doping profile, including channel implants, source/drain region implants, lightly doped drain (LDD) extension implants, and pocket/halo implants, which is not scalable further (e.g., cannot be further reduced in size), because of an increase in dopant fluctuations and stronger parasitic short channel effects, due to lack of potential control in the channel region and the deep substrate. Therefore, one proposed new design concept is a fully depleted planar SOI MOSFET device, which is formed on an SOI substrate.

For classical bulk MOSFET devices, it is expected that conventional high performance CMOS devices will require both high k dielectric materials and metal gate electrodes to eliminate poly depletion, as devices scale down to the 1 nm equivalent oxide thickness (EOT) (e.g., for the gate material). The potential metal gate materials must exhibit band-edge work functions, exhibit work function stability as a function of temperature, and maintain thermal stability with the underlying dielectric. The semiconductor industry is struggling to find adequate n-type and p-type metal materials to use as gate electrodes for the conventional bulk MOSFET, wherein the work function of adequate n-type and p-type metal would be about 4.1 eV for n-type and 5.2 eV for p-type.

Embodiments of the present invention achieve technical advantages by disclosing metals that are useful as a gate material in a CMOS transistor, for both an NMOS transistor and a PMOS transistor. In one embodiment, the gate material preferably comprises TiSiN. In other embodiments, the gate material preferably comprises TaN or TiN. The work function of the NMOS transistor and PMOS transistor is adjusted by tuning or adjusting the thickness of the gate material. Because the gate material adjacent the gate dielectric is a metal, Fermi-pinning effects caused by the use of high k dielectric materials for the gate dielectric are avoided. In some embodiments, the gate of the NMOS and PMOS transistor may also include a layer of semiconductive material disposed at a top surface thereof, for example.

The present invention will be described with respect to preferred embodiments in a specific context, namely in a CMOS device. Embodiments of the present invention may also be applied, however, to other semiconductor device applications where two or more transistors are utilized, as examples. Note that in the drawings shown, only one CMOS device is shown; however, there may be many transistors formed on a semiconductor workpiece during each of the manufacturing processes described herein.

The present invention provides a means of implementing near-mid-gap dual metal gates into a CMOS device process flow, e.g., a CMOS device built on an SOI substrate. Instead of implementing two different gate materials, the required work functions are defined or adjusted by different layer thicknesses of the gate layer using layer deposition and etch-back processes. Embodiments of the invention involve forming metal gates of CMOS devices, wherein the metal comprises a material wherein the work function can be tuned by adjusting the thickness. For example, TiSiN deposited by chemical vapor deposition (CVD) may be used as the metal gate material of CMOS devices. The work function of TiSiN can be tuned by thickness. For example, for TiSiN, the work function of a thinner film, e.g., having a thickness of about 25 Angstroms, is around 4.4 eV on a Hf-based high k film, and the work function of a thicker film e.g., having a thickness of about 200 Angstroms, is around 4.8 eV on a Hf-based high k film. Advantageously, a metal such as TiSiN can be used as a metal gate of both the NMOS and PMOS transistors of a CMOS device. Instead of adjusting the threshold voltage of a MOSFET with a doping profile (e.g., of the channel region), the metal gate materials disclosed herein may also be used if the channel region of the CMOS device is undoped.

Next, some definitions of terms used herein will next be described. The term, "mid-gap gate work function" is defined herein to be around 4.65 eV, because this is the "mid" or middle value of the work functions of n-doped polycrystalline silicon with a work function of approximately 4.1 eV, and p-doped poly-crystalline silicon having a work function of approximately 5.2 eV, as examples. The difference between 4.1eV and 5.2 eV is the energy gap of 1.1eV between the valence band and the conduction band of silicon, for example. The term, "near mid-gap" as used herein is defined to be a work function of close to about 4.65 eV; e.g., 4.45 eV is a near mid-gap work function for an NMOS transistor, and 4.85 eV is a near-mid-gap work function for a PMOS transistor of a CMOS device.

Embodiments of the present invention include providing two near mid-gap metal gate layers having work functions of around 4.45 eV and 4.85 eV. Another embodiment of the present invention includes integrating these two metal gates layers into a manufacturing process flow for a CMOS device. The work function of the PMOS device and NMOS device is adjusted using the material layer thickness. The metal layers described herein can be deposited and etched very accurately by varying the process conditions. The term "gate" and "gate electrode" refer to the gate of a transistor, and these terms are used interchangeably herein

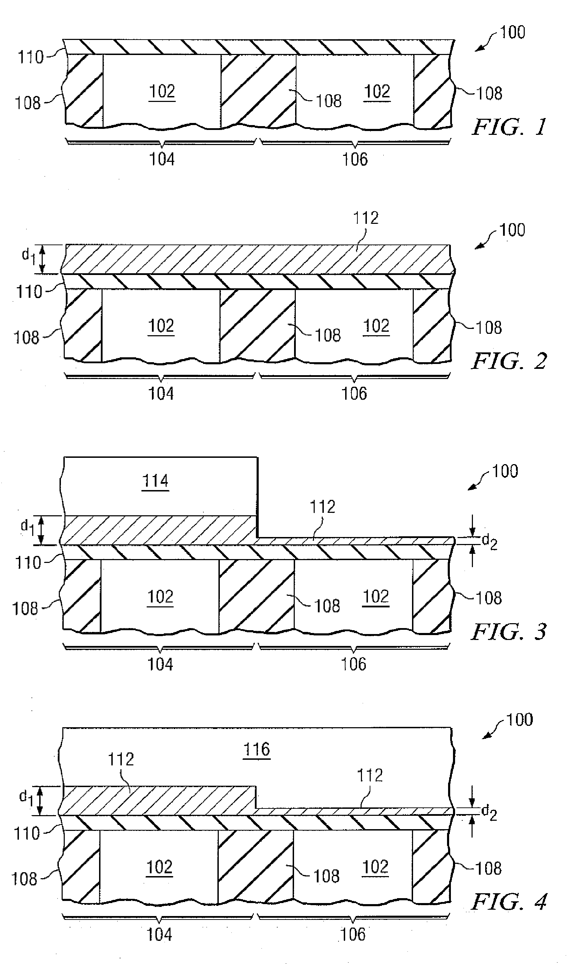

Figures 1 through 5 show cross-sectional views of a semiconductor device 100 at various stages of manufacturing in accordance with a preferred embodiment of the present invention. With reference now to Figure 1, there is shown a semiconductor device 100 in a cross-sectional view including a workpiece 102. The workpiece 102 may include a semiconductor substrate comprising silicon or other semiconductive materials covered by an insulating layer, for example. The workpiece 102 may also include other active components or circuits, not shown. The workpiece 102 may comprise silicon oxide over single-crystal silicon, for example. The workpiece 102 may include other conductive layers or other semiconductor elements, e.g., transistors, diodes, etc. Compound semiconductors, GaAs, InP, Si/Ge, or SiC, as examples, may be used in place of silicon. In one embodiment, the workpiece 102 preferably comprises a silicon-on-insulator (SOI) substrate, including a first layer of semiconductive material (not shown), a buried insulating layer or buried oxide layer (also not shown) disposed over the first layer of semiconductive material, and a second layer of semiconductive material disposed over the buried insulating layer, for example.

The workpiece 102 may be doped with P type dopants and N type dopants, e.g., to form a P well and N well, respectively (not shown). For example, a PMOS device is typically implanted with N type dopants, e.g., in a first region 104, and an NMOS device is typically implanted with P type dopants, e.g., in a second region 106. The workpiece 102 may be cleaned using a pre-gate cleaning process to remove contaminants or native oxide from the top surface of the workpiece 102. The pre-gate treatment may comprise a HF, HCl, or an ozone based cleaning treatment, as examples, although the pre-gate treatment may alternatively comprise other chemistries.

A shallow trench isolation (STI) region 108 is formed between what will be active areas in the first and second regions 104 and 106 of the workpiece 102. If the workpiece 102 comprises an SOI substrate 102, the shallow trench isolation region 108 may be formed by patterning the second layer of semiconductive material of the workpiece 102, and filling the patterned second layer of semiconductive material with an insulating material such as silicon dioxide, although other materials may be used, for example. The STI region 108 may be formed in the second layer of semiconductive material of the workpiece, and the etch process for the STI region 108 trenches may be adapted to stop on the buried insulating layer of the SOI substrate 102, for example.

A gate dielectric material 110 is formed over the workpiece 102. The gate dielectric material 110 preferably comprises a high k dielectric material having a dielectric constant of about 4.0 or greater, in one embodiment, for example. The gate dielectric material 110 may alternatively comprise a dielectric material such as SiO₂, for example. The gate dielectric material 110 preferably comprises HfO₂, HfSiOₓ, Al₂O₃, ZrO₂, ZrSiO_{X}, Ta₂O₅, La₂O₃, nitrides thereof, SiₓN_{y}, SiON, HfAlOₓ, HfAlOₓN_{1-x-y}, ZrAlOₓ, ZrAlOₓN_{y}, SiAlOₓ, SiAlOₓN_{1-x-y}, HfSiAlOₓ, HfSiAlOₓN_{y}, ZrSiAlOₓ, ZrSiAlOₓN_{y}, SiO₂, combinations thereof, or multiple layers thereof, as examples, although alternatively, the gate dielectric material 110 may comprise other high k dielectric materials or other dielectric materials.

The gate dielectric material 110 may comprise a single layer of material, or alternatively, the gate dielectric material 110 may comprise two or more layers. In one embodiment, one or more of these materials can be included in the gate dielectric material 110 in different combinations or in stacked layers. The gate dielectric material 110 may be formed by chemical vapor deposition (CVD), atomic layer deposition (ALD), metal organic chemical vapor deposition (MOCVD), physical vapor deposition (PVD), or jet vapor deposition (JVD), as examples, although alternatively, the gate dielectric material 110 may be formed using other techniques.

The gate dielectric material 110 preferably comprises a thickness of about 50 Angstroms or less in one embodiment, although alternatively, the gate dielectric material 110 may comprise other dimensions, such as about 80 Angstroms or less, as an example. The gate dielectric material 110 preferably comprises about 20 to 30 Angstroms, in one embodiment, for example.

In one embodiment, the gate dielectric material 110 preferably comprises about 10 Angstroms of SiO₂ disposed over the workpiece 102 and about 30 Angstroms of HfSiO₂ disposed over the SiO₂ Alternatively, the gate dielectric material 110 may comprise other materials, combinations of materials, and thicknesses, as examples.

Next, a gate material 112 is formed over the gate dielectric material 110, as shown in Figure 2. The gate material 112 preferably comprises a layer of TiSiN, in accordance with some embodiments of the present invention. The gate material 112 alternatively may comprise other metals in which the work function of the metal may be adjusted, tuned, or altered by varying the thickness of the metal, for example, such as TiN or TaN, as examples, although alternatively, the gate material 112 may comprise other metal materials. The gate material 112 is preferably deposited using MOCVD in one embodiment, although alternatively, the gate material 112 may be formed by ALD, PVD, or other deposition techniques, as examples.

The gate material 112 preferably comprises a first thickness d₁. The first thickness d₁ preferably comprises a thickness of about 500 Angstroms or less, and more preferably comprises a thickness of about 200 Angstroms in one embodiment, as examples, although alternatively, the first thickness d₁ may comprise other dimensions.

Next, a layer of photoresist 114 is deposited over the gate material 112, as shown in Figure 3. The layer of photoresist 114 is patterned using lithography techniques, to remove the layer of photoresist 114 from over the second region 106 of the workpiece 102. At least a portion of the gate material 112 is etched away using an etch process, also shown in Figure 3. The etch process may comprise a timed etch process and/or a wet etch process, as examples, although alternatively, other etch processes may be used. The layer of photoresist 114 protects the gate material 112 during the etch process, for example.

The gate material 112 in the second region 106 after the etch process preferably comprises a second thickness d₂, as shown in Figure 3. The second thickness d₂ is preferably less than the first thickness d₁, for example, and even more preferably, the first thickness d₁ is greater than the second thickness d₂ by at least 50 Angstroms or more, for example. The second thickness d₂ preferably comprises about 100 Angstroms or less, and more preferably comprises a thickness of about 25 Angstroms, as examples, although alternatively, the second thickness d₂ may comprise other dimensions, for example. The layer of photoresist 114 is then removed.

Next, optionally, a semiconductive material 116 is deposited over the gate material 112, as shown in Figure 4. The semiconductive material 116 comprises part of a gate electrode of the transistors formed in the first region 104 and second region 106, for example. The semiconductive material 116 preferably comprises about 1,000 Angstroms of polysilicon, for example, although alternatively, the semiconductive material 116 may comprise other dimensions and materials.

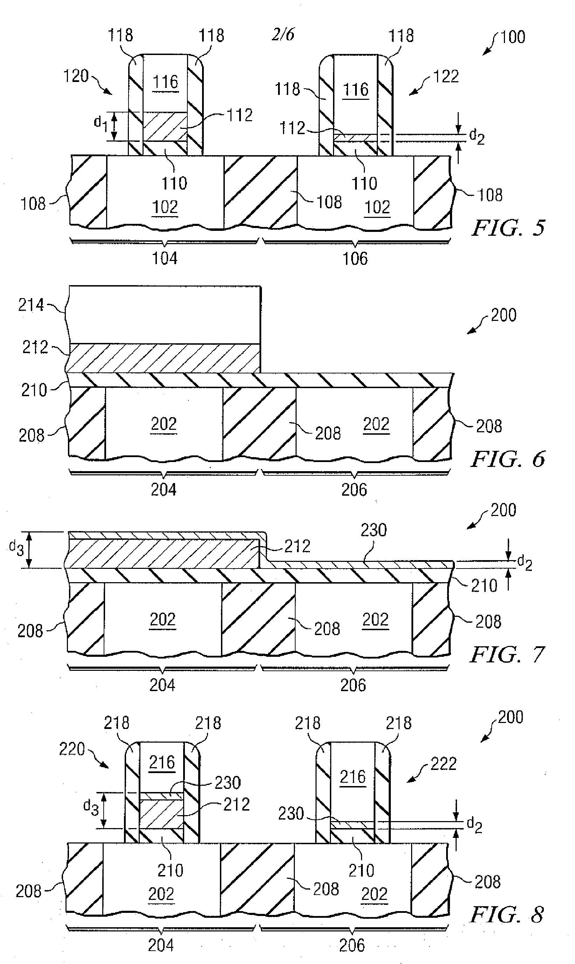

Next, the gate materials 116 and 112 and the gate dielectric material 110 are patterned using lithography to form a gate 112/116 and a gate dielectric 110 of a PMOS transistor 120 in the first region 104 and an NMOS transistor 122 in the second region 106, as shown in Figure 5. For example, a layer of photoresist (not shown) may be deposited over the gate material semiconductive material 116, and the photoresist may be patterned using a lithography mask and an exposure process. The photoresist is developed, and the photoresist is used as a mask while portions of the gate materials 116 and 112 and gate dielectric material 110 are etched away.

The workpiece 102 may be implanted with dopants to form source and drain regions (not shown) proximate the gate dielectric 110. Spacers 118 comprising an insulating material such as an oxide, nitride, or combinations thereof, may be formed over the sidewalls of the gate 112/116 and gate dielectric 110, as shown in Figure 5.

Processing of the semiconductor device 100 is then continued, such as forming insulating and conductive layers over the transistors 120 and 122, as examples (not shown). For example, one or more insulating materials (not shown) may be deposited over the transistors 120 and 122, and contacts may be formed in the insulating materials in order to make electrical contact with the gate 112/116, and source and/or drain regions. Additional metallization and insulating layers may be formed and patterned over the top surface of the insulating material and contacts. A passivation layer (not shown) may be deposited over the insulating layers or the transistors 120 and 122. Bond pads (also not shown) may be formed over contacts, and a plurality of the semiconductor devices 100 may then be singulated or separated into individual die. The bond pads may be connected to leads of an integrated circuit package (not shown) or other die, for example, in order to provide electrical contact to the transistors 120 and 122 of the semiconductor device 100.

The transistors 120 and 122 preferably comprise a PMOS transistor 120 and an NMOS transistor 122, in one embodiment. The metal layer 112 is preferably thicker in the PMOS transistor 120 than in the NMOS transistor 122, in accordance with embodiments of the present invention, The first thickness d₁ of the metal layer 112 in the PMOS transistor 120 causes the gate material 112 to have a work function of about 4.85 eV, in one embodiment. The second thickness d₂ of the metal layer 112 in the NMOS transistor 122 causes the gate material 112 to have a work function of about 4.45 eV, in one embodiment. The transistors 120 and 122 preferably have substantially symmetric threshold voltages of about +0.3 and -0.3 V, respectively, as examples, in one embodiment, although the threshold voltages may alternatively comprise other voltage levels.

Another preferred embodiment of the present invention is shown in a cross-sectional view in Figures 6 through 8 at various stages of manufacturing. Like numerals are used for the elements in Figures 6 through 8 as were used in Figures 1 through 5, and to avoid repetition, the descriptions of the elements and formation thereof are not repeated herein.

In this embodiment, during the etch process to reduce the thickness of the metal layer 212 in the second region 206, all of the metal layer 212 is removed in the second region 206, as shown in Figure 6. Then, another metal layer 230 is deposited over the first metal layer 212 in the first region 204, and over the exposed gate dielectric 210 in the second region 206, as shown in Figure 7. Processing of the semiconductor device 200 is then continued as described with reference to Figure 5, leaving the structure shown in Figure 8.

The first metal layer 212 as deposited preferably comprises a thickness of about 200 Angstroms, in one embodiment. The second metal layer 230 preferably comprises a thickness of about 25 Angstroms. The thickness d₃ of the metal portion of the gate 212/230 of the PMOS transistor 220 in the first region 204 preferably comprises about 225 Angstroms, for example. The thickness d₂ of the metal portion of the gate 230 of the NMOS transistor 222 in the second region 206 preferably comprises about 25 Angstroms, for example. However, alternatively, the metal layers 212 and 230 may comprise other dimensions, for example.

Note that after depositing the layer of semiconductive material 216, the layer of semiconductive material 216 may be doped using an implantation process with dopants. For example, if the transistor 220 comprises a PMOS transistor, the semiconductive material 216 is preferably implanted with a P type dopant. Alternatively, the semiconductive material 216 may be implanted with an N type dopant, for example. However, the semiconductive material 216 may alternatively be implanted with other types of dopants, or may not be doped at all.

After implanting the semiconductive material 216 with a dopant, the layer of semiconductive material 216, the gate materials 230 and 212, and the gate dielectric material 210 are patterned, and processing of the semiconductor device 200 is then continued as described with reference to Figures 1 through 5, as shown in Figure 8.

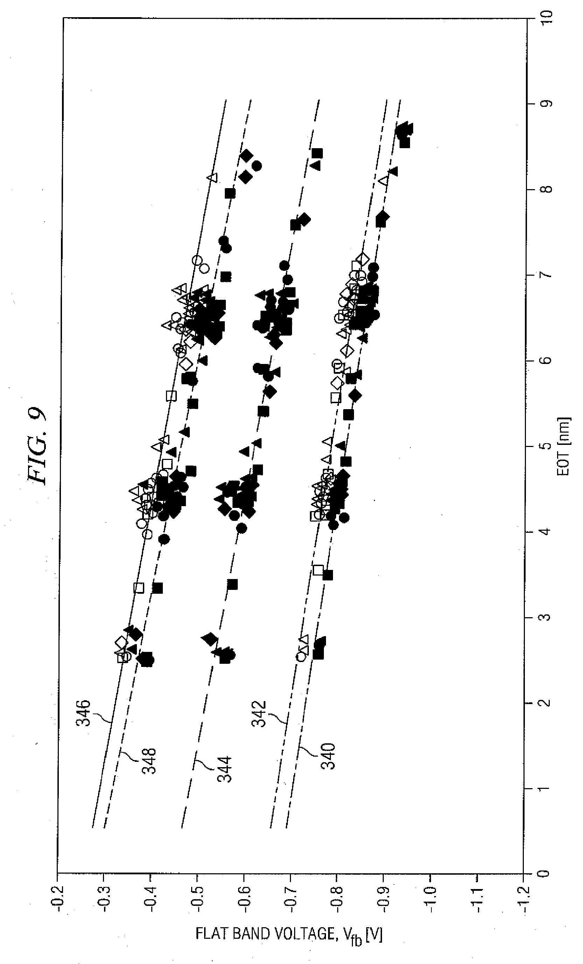

Figures 9 through 12 are graphs illustrating experimental test results of flat band voltage (V_{fb}) in volts (V) versus effective oxide thickness (EOT) at various test conditions and device configurations for NMOS devices, showing that TiSiN is an effective material that may be used as a gate material to achieve the desired work function of the PMOS and NMOS transistors of a CMOS device, by varying the thickness of the TiSiN.

For example, referring next to Figure 9, a graph of test results of a semiconductor device 100 is shown, wherein the metal gate material comprised TiSiN, and the gate dielectric of both the NMOS and PMOS device comprises about 20 Angstroms of HfOₓ. Graph 340 shows test results, in flat band voltage vs. EOT (in nm) for N_{f}, which indicates the fixed charge at the interface between the dielectric film and substrate, of about 5.93 x 10¹¹/cm², and having a work function of about 4.4 eV, for a metal layer of about 25 Angstroms. Graph 342 shows test results for an N_{f} of about 6.06 x 10¹¹/cm², and having a work function of about 4.43 eV, for a metal layer of about 50 Angstroms. Graph 344 shows test results of about 7.17 x 10¹¹/cm², and having a work function of about 4.63 eV, for a metal layer of about 100 Angstroms. Graph 346 shows test results of about 6.82 x 10¹¹/cm², and having a work function of about 4.81 eV, for a metal layer of about 200 Angstroms. Graph 348 shows test results of about 7.54 x 10¹¹/cm², and having a work function of about 4.79 eV, for a metal layer of about 400 Angstroms. Note that at about 200 Angstroms, the work function of TiSiN becomes saturated, e.g., increasing the TiSiN thickness greater than 200 Angstroms to 400 Angstroms does not further increase the work function.

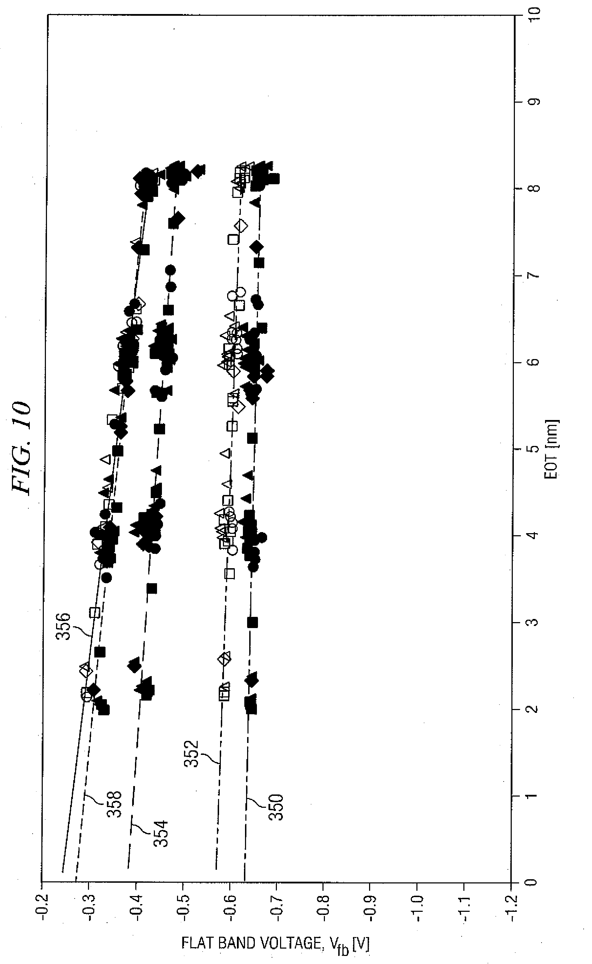

Figure 10 shows a similar plot for an NMOS device having a gate comprised of TiSiN and a gate dielectric of about 30 Angstroms of HfSiOₓ. Graph 350 shows test results, in V_{fb} vs. EOT N_{f}, of about 5.49 x 10¹⁰/cm², and having a work function of about 4.44 eV, for a metal layer of about 25 Angstroms. Graph 352 shows test results for an N_{f} of about 1.16 x 11¹¹/cm², and having a work function of about 4.5 eV, for a metal layer of about 50 Angstroms. Graph 354 shows test results of about 2.48 x 10¹¹/cm², and having a work function of about 4.69 eV, for a metal layer of about 100 Angstroms. Graph 356 shows test results of about 4.58 x 10¹¹/cm², and having a work function of about 4.83 eV, for a metal layer of about 200 Angstroms, Graph 358 shows test results, of about 3.63 x 10¹¹/cm², and having a work function of about 4.8 eV, for a metal layer of about 400 Angstroms. Again, the TiSiN work function becomes saturated at a thickness of about 200 Angstroms.

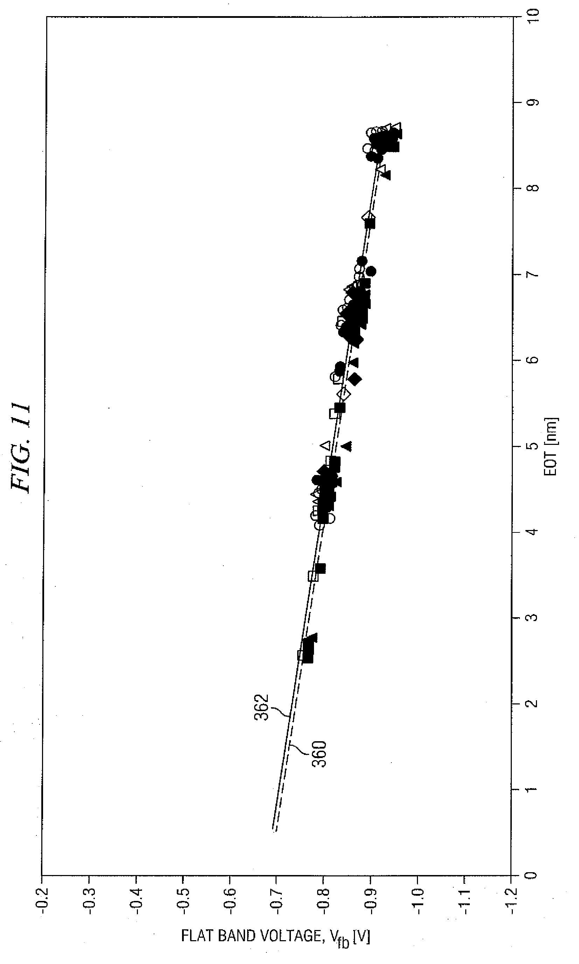

Figure 11 illustrates a comparison of the use of an n-poly cap with a p-poly cap (e.g., the gate electrodes of the PMOS and NMOS transistor include the optional semiconductive material 116 or 216), wherein the poly caps comprises a thickness of about 1,000 Angstroms, in a TiSiN over a 20 Angstroms thick HfOₓ structure. At 360, the test results for p-poly disposed over about 25 Angstroms of TiSiN over 20 Angstroms of HfOₓ is shown, at an N_{f} of 5.95 x 10¹¹/cm² and a work function of 4.39 eV. At 362, the test results for n-poly disposed over 25 Angstroms of TiSiN disposed over 20 Angstroms of HfOₓ is shown, at an N_{f} of 5.93 x 10¹¹/cm² and a work function of 4.4 eV. The identical work function from both the n-poly cap and p-poly cap gate electrodes indicates that even though the TiSiN layer is thin (25 Angstroms), the film is continuous and sufficient to control the work function. The term "continuous" refers to the finding by the inventors of the present invention that although 25 Angstroms is extremely thin, TiSiN formed at a thickness of 25 Angstroms was not found to form islands of material, as can occur with some thin films; rather, advantageously, the 25 Angstrom thick layer of TiSiN was found to form a thin layer of material having a continuous coverage of the underlying material layer. Thus, such a thin layer of TiSiN is useful as a gate electrode material of a transistor, for example.

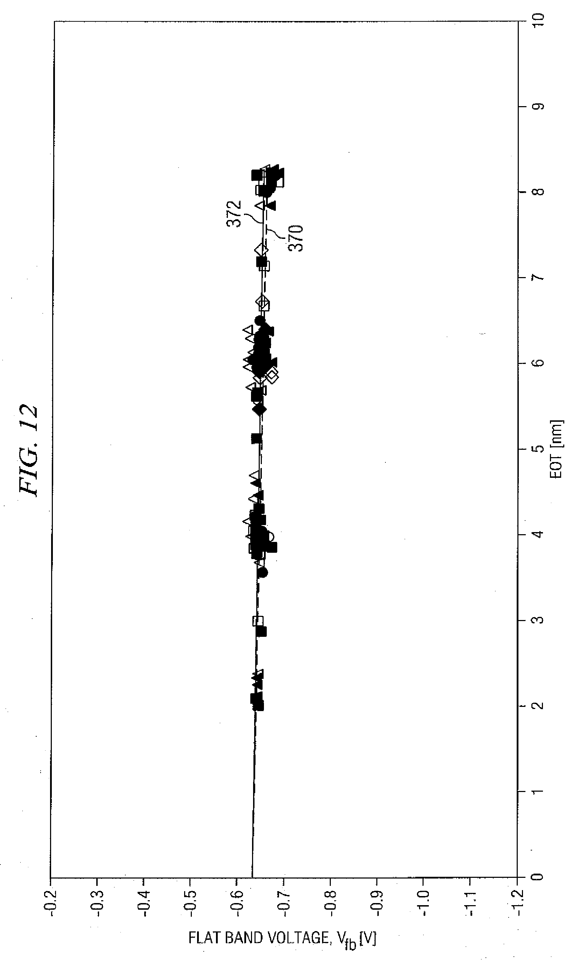

Figure 12 illustrates a comparison of the use of an n-poly cap with a p-poly cap having a thickness of about 1,000 Angstroms, in a TiSiN over an HfSiOₓ structure. At 370, the test results for p-poly disposed over a 25 Angstroms thick structure of TiSiN/HfSiOₓ is shown, at an N_{f} of 6.6495 x 10¹⁰/cm² and a work function of 4.44 eV. At 372, the test results for n-poly disposed over a 25 Angstroms thick structure of TiSiN/HfSiOₓ is shown, at an N_{f} of 5.49 x 10¹⁰/cm² and a work function of 4.44 eV. Again, a 25 Angstroms thickness of the TiSiN was found to be continuous and sufficient to control the work function, advantageously.

The results shown in Figure 9 through 12 show that the work function is reliable for the various TiSiN thicknesses tested. In accordance with the experimental results of the novel invention described herein, the work function of a 25 Angstroms thick layer of TiSiN has been found to be about 4.44 eV disposed on a dielectric layer of HfSiOₓ, and about 4.40 eV disposed on a dielectric layer of HfOₓ. The work function of a 200 Angstroms thick layer of TiSiN has been found to be about 4.83 eV disposed on a dielectric layer of HfSiOₓ, and about 4.81 eV disposed on a dielectric layer of HfOₓ. Advantageously, these TiSiN material layers may be implemented in CMOS devices to achieve the desired work function and voltage threshold of the CMOS devices. Preferably, about 25 Angstroms of TiSiN is used as a gate electrode of an NMOS device, and about 200 Angstroms of TiSiN is used as a gate electrode of a PMOS device, if the gate dielectric comprises a Hf-based gate dielectric, for example, to achieve a symmetric Vₜ for the CMOS device.

While test results are not included for TaN and TiN, these materials have also been found to have an adjustable work function, based on the film thickness.

Embodiments of the present invention achieve technical advantages in several different device applications. For example, embodiments of the invention may be implemented in NMOS high performance (HP) devices, NMOS low operation power (LOP) devices, NMOS Low Standby Power (LSTP) devices, PMOS high performance devices, PMOS low operation power devices, and PMOS Low Standby Power devices, as examples. The parameters for these HP devices, LOP devices, and LSTP devices, are defined in the 2002 edition of International Technology Roadmap for Semiconductors (ITRS), incorporated herein by reference. Preferably, in accordance with embodiments of the present invention, all devices of one type (e.g., either NMOS or PMOS) will have the same implantation doping levels, but may have different gate electrode layer thicknesses, according to the type of device, e.g., HP, LOP, or LSTP. Additional implantation processes are optional, but are not necessary, for example.

Thus, novel semiconductor devices 100 and 200 comprising CMOS devices having PMOS and NMOS devices comprising a metal are formed in accordance with embodiments of the present invention. Advantages of preferred embodiments of the present invention include providing methods of fabricating semiconductor devices 100 and 200 and structures thereof. The PMOS and NMOS transistors have a substantially symmetric Vₜ. For example, Vₜₚ is preferably about -0.3 V, and Vₜₙ may be the substantially the same positive value, e.g., about +0.3 V. The thickness of the metal gate layer sets the work function of the gates 112, 112/116 (e.g., if the gate includes the semiconductive material layer 116), 212/230, 230, 212/230/216, and 230/216, of transistor devices 120,122, 220, and 222, for example.

Although embodiments of the present invention and their advantages have been described in detail, it should be understood that various changes, substitutions and alterations can be made herein without departing from the spirit and scope of the invention as defined by the appended claims. For example, it will be readily understood by those skilled in the art that many of the features, functions, processes, and materials described herein may be varied while remaining within the scope of the present invention. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed, that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A semiconductor device, comprising:
a first transistor, the first transistor including a first gate electrode, the first gate electrode having a first thickness; and
a second transistor proximate the first transistor, the second transistor including a second gate electrode, the second gate electrode having a second thickness, the second thickness being different than the first thickness.

2. The semiconductor device according to Claim 1, wherein the first gate electrode and the second gate electrode comprise TiSiN, TaN, or TiN.

3. The semiconductor device according to Claim 1, wherein the semiconductor device comprises a complementary metal oxide semiconductor (CMOS) device, wherein the first transistor comprises a PMOS transistor, wherein the second transistor comprises an NMOS transistor, and wherein the first thickness is greater than the second thickness.

4. The semiconductor device according to Claim 3, wherein the first thickness is greater than the second thickness by about 50 Angstroms or more.

5. The semiconductor device according to Claim 3, wherein the first thickness comprises about 500 Angstroms or less, and wherein the second thickness comprises about 100 Angstroms or less.

6. The semiconductor device according to Claim 5, wherein the first thickness comprises about 200 Angstroms, and wherein the second thickness comprises about 25 Angstroms.

7. The semiconductor device according to Claim 1, wherein the first gate electrode comprises the same material as the second gate electrode.

8. The semiconductor device according to Claim 1, wherein the first gate electrode and the second gate electrode comprise a first layer and a second layer disposed over the first layer, wherein the first layer comprises a metal, and wherein the second layer comprises a semiconductive material.

9. The semiconductor device according to Claim 8, wherein the second layer comprises a thickness of about 2,000 Angstroms or less, and wherein the second layer comprises polysilicon.

10. The semiconductor device according to Claim 1, wherein the first gate electrode comprises a first metal layer and a second metal layer disposed over the first metal layer, and wherein the second gate electrode comprises the second metal layer.

11. The semiconductor device according to Claim 1, further comprising:
a gate dielectric disposed beneath the first gate electrode and the second gate electrode; and
a workpiece disposed beneath the gate dielectric, the workpiece including a source region and a drain region proximate each gate dielectric.

12. The semiconductor device according to Claim 11, wherein the gate dielectric comprises a hafnium-based dielectric, HfO₂, HfSiO_{X}, Al₂O₃, ZrO₂, ZrSiOₓ, Ta₂O₅, La₂O₃, nitrides thereof, SiₓN_{y}, SiON, HfAlOₓ, HfAlOₓN_{1-x-y}, ZrAlOₓ, ZrAlOₓN_{y}, SiAlOₓ, SiAlOₓN_{1-x-y}, HfSiAlOₓ, HfSiAlOₓN_{y}, ZrSiAlOₓ, ZrSiAlOₓN_{y}, SiO₂, combinations thereof, or multiple layers thereof.

13. The semiconductor device according to Claim 1, wherein the first gate electrode and the second gate electrode have a work function of about 4.4 to 4.9 eV.

14. A semiconductor device, comprising:
a positive channel metal oxide semiconductor (PMOS) transistor including a first gate electrode comprising a first thickness; and
a negative channel metal oxide semiconductor (NMOS) transistor including a second gate electrode comprising a second thickness, the second thickness being less than the first thickness, the second gate electrode comprising the same material as the first gate electrode, wherein the first thickness and the second thickness of the first gate electrode and the second gate electrode, respectively, set the work function of the PMOS transistor and the NMOS transistor, respectively.

15. The semiconductor device according to Claim 14, wherein the first gate electrode and the second gate electrode comprise TiSiN, TaN, or TiN.

16. The semiconductor device according to Claim 14, wherein the PMOS transistor comprises a first PMOS transistor, wherein the NMOS transistor comprises a first NMOS transistor, further comprising at least one second PMOS transistor including a third gate electrode comprising a third thickness, and at least one second NMOS transistor including a fourth gate electrode comprising a fourth thickness, wherein the third thickness and the fourth thickness are different than the first thickness and the second thickness.

17. The semiconductor device according to Claim 16, wherein the first PMOS transistor and the first NMOS transistor comprise a first CMOS device, wherein the at least one second PMOS transistor and the at least one second NMOS transistor comprise at least one second CMOS device, wherein the first CMOS device comprises a first device type, wherein the at least one second CMOS device comprises a second device type, wherein the second device type is different from the first device type, and wherein the first device type and the second device type comprise a high performance (HP) device, a low operation power (LOP) device, or a low standby power (LSTP) device.

18. A method of manufacturing a semiconductor device, the method comprising:
providing a workpiece;
forming a gate dielectric material over the workpiece;
forming a gate electrode material over the gate dielectric material, the gate electrode material having a first thickness in a first region and a second thickness in a second region, the second thickness being different than the first thickness;
patterning the gate electrode material and the gate dielectric material to form a gate electrode and a gate dielectric of a first transistor in the first region and a gate electrode and a gate dielectric of a second transistor in the second region; and
forming a source region and a drain region in the workpiece proximate the gate dielectric of the first transistor and the second transistor.

19. The method according to Claim 18, wherein forming the gate electrode material comprises forming TiSiN, TaN, or TiN.

20. The method according to Claim 18, wherein forming the gate electrode material comprises depositing a first layer of a metal over the gate dielectric material over the first region and the second region, and removing at least a portion of the gate electrode material in the second region.

21. The method according to Claim 20, wherein removing at least the portion of the gate electrode material in the second region comprises removing all of the gate electrode material in the second region.

22. The method according to Claim 21, further comprising depositing a second layer of metal over the gate dielectric material in at least the second region.

23. The method according to Claim 22, wherein depositing the second layer of metal over the gate dielectric material further comprises depositing the second layer of metal in the first region.

24. The method according to Claim 18, wherein forming the gate dielectric comprises forming a hafnium-based dielectric, HfO₂, HfSiOₓ, Al₂O₃, ZrO₂, ZrSiOₓ, Ta₂O₅, La₂O₃, nitrides thereof, SiₓN_{y}, SiON, HfAlOₓ, HfAlOₓN_{1-x-y}, ZrAlOₓ, ZrAlOₓN_{y}, SiAlOₓ, SiAlOₓN_{1-x-y}, HfSiAlOₓ, HfSiAlOₓN_{y}, ZrSiAlOₓ, ZrSiAlOₓN_{y}, SiO₂, combinations thereof, or multiple layers thereof.

25. The method according to Claim 18, wherein providing the workpiece comprises providing a silicon-on-insulator (SOI) substrate.

26. The method according to Claim 18, wherein forming the gate electrode material comprises forming a metal layer, and forming a layer of semiconductive material over the metal layer.
